(19) Europäisches Patentamt / European Patent Office / Office européen des brevets

(11) **EP 4 253 973 A1**

(12) **DEMANDE DE BREVET EUROPEEN**

(43) Date de publication:
**04.10.2023 Bulletin 2023/40**

(21) Numéro de dépôt: **23164241.4**

(22) Date de dépôt: **27.03.2023**

(51) Classification Internationale des Brevets (IPC):
**G01R 31/367** (2019.01)    **G01R 31/36** (2020.01)
**G01R 31/385** (2019.01)    **B07C 5/344** (2006.01)
**H01M 10/42** (2006.01)

(52) Classification Coopérative des Brevets (CPC):
**G01R 31/3648; G01R 31/367; G01R 31/3865;
H01M 10/0525; H01M 10/4285; H01M 10/48;
H01M 10/482**

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**KH MA MD TN**

(30) Priorité: **31.03.2022 FR 2202945**

(71) Demandeur: **COMMISSARIAT À L'ÉNERGIE
ATOMIQUE ET AUX
ÉNERGIES ALTERNATIVES
75015 Paris (FR)**

(72) Inventeurs:
• **SECOUARD, Christophe
38054 GRENOBLE CEDEX 09 (FR)**
• **OUKASSI, Sami
38054 GRENOBLE CEDEX 09 (FR)**

(74) Mandataire: **Atout PI Laplace
Immeuble "Visium"
22, avenue Aristide Briand
94117 Arcueil Cedex (FR)**

(54) **PROCÉDÉ DE TRI D'UN ENSEMBLE DE BATTERIES BASÉ SUR UN MODÈLE DE CLASSIFICATION AUTOMATIQUE**

(57)    Procédé, mis en oeuvre par ordinateur, d'apprentissage automatique (101) d'un modèle de classification de batteries en deux catégories : fonctionnel ou défectueux, le procédé comprenant les étapes de :
- Acquérir (110), sur un ensemble de batteries de même type, un groupe de mesures caractéristiques du fonctionnement d'une batterie,
- Réaliser (111) un cyclage complet de chaque batterie dudit ensemble et mesurer au moins une courbe parmi une courbe de charge ou une courbe de décharge de la batterie,
- Déterminer (111), pour chaque batterie, un label d'appartenance à la catégorie fonctionnel ou défectueux en comparant au moins une courbe mesurée à une courbe de référence caractérisant le bon fonctionnement de la batterie, et
- Réaliser (112) un entrainement supervisé d'un modèle de classification d'une batterie selon les deux catégories à partir desdits groupes de mesures et dudit label d'appartenance à l'une des deux catégories.

FIG.1

EP 4 253 973 A1

**Description**

L'invention concerne le domaine des méthodes de test électrique de dispositifs de stockage d'énergie communément appelés batteries ou microbatteries en cours ou à l'issue de leur fabrication en vue de trier et éliminer les produits non conformes.

Une microbatterie est réalisée par un dépôt successif sur un substrat des éléments suivants : (i) un premier collecteur de courant, (ii) une première électrode, (iii) une couche d'électrolyte, (iv) une deuxième électrode, et (v) un deuxième collecteur de courant. Une encapsulation par le biais de dépôt de couches supplémentaires, ou par report de capot est nécessaire pour protéger le dispositif de la réactivité chimique avec l'oxygène et la vapeur d'eau.

Ainsi, une microbatterie est essentiellement composée de deux électrodes (une électrode positive et une électrode négative) séparées par un isolant électrique et un conducteur ionique (l'électrolyte), et dans lequel les ions (par exemple des ions lithium, $Li^+$) transitent d'une électrode à l'autre suivant que l'on charge ou que l'on décharge la microbatterie.

Par exemple, une microbatterie à l'état solide peut être définie comme une batterie qui présente toutes les caractéristiques suivantes :

- Toutes les couches actives (c'est-à-dire l'électrode positive, l'électrolyte et l'électrode négative) sont constituées uniquement de matériau inorganique à l'état solide. En règle générale, cela signifie qu'il n'y a pas d'électrolyte polymère liquide ou en gel et pas de matériau d'électrode qui contient des liants polymères comme c'est le cas dans les « batteries standards »,

- L'épaisseur individuelle de toutes les couches actives (c'est-à-dire l'électrode positive, l'électrolyte et l'électrode négative) est inférieure à 50 $\mu$m. De plus, l'épaisseur de l'électrolyte est généralement inférieure à 5 $\mu$m, et

- Pour les batteries standard, l'épaisseur de chaque couche est généralement supérieure à 100 $\mu$m. Les dimensions de surface varient généralement de mm$^2$ à 10 cm$^2$ ".

De manière générale, les microbatteries peuvent être classées en trois catégories en fonction du type d'électrode négative (ou anode), souvent déposée au-dessus de l'électrolyte :

- anode en matériau de stockage des ions Li+ : il s'agit souvent d'oxydes de métaux de transition (Vox, TiOx, NiOx, etc..) ou de matériaux cristallogènes (Si, Ge, C ou mélanges) ;

- anode en lithium métallique : une couche de lithium est déposée sous forme métallique au-dessus du collecteur ; et

- anode en métal inerte vis-à-vis du lithium : cette configuration est souvent appelée *"Li-free"* en référence à l'article J. Electrochem. Soc.-2000-Neudecker-517-23. Dans ce dernier cas une anode en lithium métallique est formée au cours de la première charge de la batterie par électrodépôt d'ions Li+ (en provenance de la cathode) entre l'électrolyte et le deuxième collecteur de courant.

Ainsi, dans les microbatteries sans lithium ou « Li-free », il n'y a pas d'électrode négative en sortie du procédé de fabrication. Celle-ci est créée au cours de la première charge.

Les microbatteries sont généralement utilisées dans des domaines d'applications variés (internet des objets, implants médicaux, capteurs autonomes...) qui nécessitent la production de composants de taille submillimétrique à forte densité d'énergie. Les techniques de fabrication mises en jeu, issues de la microélectronique (substrat plaque de silicium, dépôt de couches minces, photolithographie, gravure sèche/humide) permettent la réalisation d'un grand nombre de microbatteries à la fois, de l'ordre de plusieurs dizaines de milliers sur un seul substrat, dont il faut vérifier le bon fonctionnement.

En effet, à l'issue du procédé de fabrication, des défauts peuvent exister sur certains composants et il est donc impératif de les tester un par un avant de les considérer comme opérationnels.

La méthode la plus simple et la plus directe pour trier des microbatteries à l'issue de leur fabrication consiste à effectuer plusieurs cycles de charge/décharge puis à vérifier que les profils de courant, de tension, ainsi que les valeurs de capacité et de résistance interne sont conformes à ce qui est attendu.

Cependant, cette approche comporte plusieurs inconvénients. Avec plusieurs heures, voire jours nécessaires par dispositif, le temps de test mis en jeu est trop important pour que ce procédé soit viable dans un contexte industriel d'autant plus compte tenu du nombre de dispositifs mis en jeu dans les applications visées.

D'autre part, le cyclage complet des batteries entraine la modification de la structure cristalline de l'empilement, le vieillissement des interfaces, et la migration d'ions Li+ ce qui rend les dispositifs extrêmement sensibles à l'humidité et l'atmosphère ambiante et peut empêcher la poursuite de la réalisation des procédés restants si ce test est réalisé en cours de fabrication. Enfin, les batteries testées ne sont plus commercialisables, étant donné que le vieillissement du composant a déjà été initié.

L'art antérieur comporte différents exemples de méthodes de tri de batteries ou microbatteries basées sur des tests rapides.

La demande de brevet américaine US9209496 propose une méthode de tri consistant à mesurer la tension à circuit ouvert ou OCV (pour Open Circuit Voltage) d'une batterie, de la décharger pendant une certaine période et de comparer le potentiel de fin de décharge à celui de l'OCV. Il est clair que dans le cas des microbatteries *"Li-free"*, cette méthode de tri n'est pas adaptée dans la mesure où (i) l'OCV n'apporte pas d'indications concernant l'état de la batterie, et (ii) la décharge des batteries *"Li-free"* ne permet pas de modifier leur potentiel de façon stable dans la mesure où la microbatterie est totalement déchargée au moment du test.

Le brevet américain US6526361 propose une méthode de tri consistant à appliquer plusieurs impulsions successives (soit une application d'impulsions de courant, soit d'impulsions de tension) avec une période de relaxation entre chaque impulsion, à des batteries, à mesurer la réponse en tension associée et à effectuer un tri en fonction de cette réponse. Cette approche n'est pas applicable à des microbatteries de type *"Li-free"* étant donné qu'elle nécessite un état initial stable en tension.

La demande de brevet français FR3112213 du Demandeur propose de pallier les lacunes des deux méthodes précédentes par la formation d'une couche nanométrique de Lithium par le biais d'une charge par application de courant de courte durée. Ceci permet d'avoir un état stable des interfaces et d'exploiter la réponse en potentiel sur des architectures Li-free, tout en ne dégradant pas les batteries. Néanmoins, la solution proposée n'adresse pas le cas de la sollicitation en potentiel. Par ailleurs, le tri se fait par étapes successives, selon un système de cribles, nécessitant la définition de seuils : si les grandeurs mesurées à une étape donnée (telles que le potentiel, la résistance) ne sont pas comprises dans un intervalle donné, la mesure s'arrête et la batterie est considérée comme défectueuse. En outre, la définition de seuils précis, basée sur les connaissances de l'homme de l'art est souvent délicate et imprécise, surtout lorsque le nombre de variables est grand, et le fait de procéder de façon criblée peut ne pas couvrir toutes les combinaisons possibles, au risque d'éliminer des composant fonctionnels.

La présente invention vise à pallier les inconvénients des méthodes de l'état de l'art en proposant une méthode de test rapide qui n'endommage pas les batteries et qui permet de réaliser un tri des batteries selon quelles sont fonctionnelles ou défectueuses. L'invention est basée sur l'entrainement d'un modèle de classification par apprentissage automatique à partir de mesures réalisées sur un ensemble de batteries. Le modèle de classification entraîné est ensuite utilisé pour trier les batteries à l'issue de leur fabrication simplement à partir de mesures réalisées sur les batteries sans nécessité de réaliser un cyclage (charge puis décharge) de la batterie.

L'entrainement du modèle de classification met en oeuvre une charge partielle des composants par l'application d'une tension pendant une durée de l'ordre de la minute puis l'étude de la relaxation du potentiel. Ceci présente l'avantage de solliciter la batterie de la même façon que lors de l'utilisation finale, sans toutefois créer une couche de Lithium métal trop épaisse pouvant mener à une dégradation.

L'invention comporte deux phases. Dans la première phase, dite d'élaboration, un échantillon de batteries testées selon un protocole rapide est ensuite cyclé complètement et les composants sont classés en deux catégories : fonctionnel ou défectueux. L'algorithme d'apprentissage est entraîné sur ces données, de manière à pouvoir prédire en sortie le caractère fonctionnel ou non des dispositifs, avec en entrée les mesures réalisées pendant le test rapide.

Dans la deuxième phase, dite d'utilisation, une fois le modèle validé, de nouvelles batteries sont testées et le modèle de classification entraîné permet une prédiction sur leur fonctionnalité sans avoir à les cycler. Cette approche présente l'avantage de pouvoir s'affranchir de la définition de seuils pour le tri et de s'accommoder d'un grand nombre de dimensions.

L'invention s'applique avantageusement au test de batteries solides de type « Li-free » mais son principe est applicable plus généralement à tout type de batteries ou microbatteries.

L'invention a pour objet un procédé, mis en oeuvre par ordinateur, d'apprentissage automatique d'un modèle de classification de batteries en deux catégories : fonctionnel ou défectueux, le procédé comprenant les étapes de :

-    Acquérir, sur un ensemble de batteries de même type, un groupe de mesures caractéristiques du fonctionnement d'une batterie,

-    Réaliser un cyclage complet de chaque batterie dudit ensemble et mesurer au moins une courbe parmi une courbe de charge ou une courbe de décharge de la batterie,

-    Déterminer, pour chaque batterie, un label d'appartenance à la catégorie fonctionnel ou défectueux en comparant l'au moins une courbe mesurée à une courbe de référence caractérisant le bon fonctionnement de la batterie,

-    Réaliser un entrainement supervisé d'un modèle de classification d'une batterie selon les deux catégories à partir desdits groupes de mesures et dudit label d'appartenance à l'une des deux catégories.

Selon un aspect particulier de l'invention, l'entrainement supervisé du modèle de classification est réalisé au moyen d'un algorithme de forêt aléatoire.

Selon un aspect particulier de l'invention, le groupe de mesures caractéristiques du fonctionnement d'une batterie comporte au moins une mesure de tension de circuit ouvert aux bornes de la batterie, par exemple une mesure moyenne sur un intervalle de temps prédéterminé.

Selon un aspect particulier de l'invention, le groupe de mesures caractéristiques du fonctionnement d'une batterie comporte au moins une mesure de profil de courant traversant la batterie au cours d'une charge partielle.

Selon un aspect particulier de l'invention, la mesure de profil de courant est réalisée en au moins un point particulier parmi une valeur maximale de courant et une valeur de courant en fin de charge partielle.

Selon un aspect particulier de l'invention, le groupe de mesures caractéristiques du fonctionnement d'une batterie comporte au moins une mesure de profil de tension aux bornes de la batterie au cours d'une relaxation de la batterie suivant une charge partielle.

Selon un aspect particulier de l'invention, la mesure de profil de tension comporte au moins une estimation par régression linéaire de la pente de la courbe de tension au cours de la décharge et/ou la mesure d'un potentiel de fin de relaxation.

Selon un aspect particulier de l'invention, le groupe de mesures caractéristiques du fonctionnement d'une batterie comporte au moins une mesure de spectroscopie d'impédance électrochimique réalisée en excitant la batterie avec un signal à au moins une fréquence prédéterminée.

Selon un aspect particulier de l'invention, la mesure de spectroscopie d'impédance électrochimique est réalisée pour au moins deux fréquences prédéterminées à 1000 Hz et 10Hz.

Selon un aspect particulier de l'invention, le groupe de mesures caractéristiques du fonctionnement d'une batterie comporte au moins une mesure de la position d'une batterie sur une plaque de fabrication.

Selon un aspect particulier de l'invention, les batteries sont de type batteries solides Li-free.

L'invention a aussi pour objet un procédé de test d'un ensemble de batteries comprenant les étapes de, pour chaque batterie :

- Acquérir le même groupe de mesures utilisé pour entraîner le modèle de classification obtenu au moyen de l'invention, et
- Mettre en oeuvre le modèle de classification obtenu pour déterminer, à partir dudit groupe de mesures, si la batterie appartient à la catégorie fonctionnel ou défectueux.

L'invention a aussi pour objet un dispositif de test d'un ensemble de batteries comprenant un équipement de mesure et un dispositif de calcul configurés ensemble pour exécuter le procédé de test selon l'invention.

L'invention a aussi pour objet un produit programme d'ordinateur comprenant des instructions de code qui conduisent le dispositif de test selon l'invention à exécuter les étapes de l'un quelconque des procédés selon l'invention.

D'autres caractéristiques et avantages de la présente invention apparaîtront mieux à la lecture de la description qui suit en relation aux dessins annexés suivants.

[Fig. 1] représente un schéma général du principe en deux phases du procédé de test selon l'invention,

[Fig. 2] représente un diagramme d'une mesure de tension de circuit ouvert aux bornes d'une microbatterie,

[Fig. 3] représente un diagramme d'un profil de courant au cours d'une charge partielle d'une microbatterie,

[Fig. 4] représente un diagramme d'un profil de relaxation en potentiel d'une microbatterie partiellement chargée,

[Fig. 5] représente un diagramme de Nyquist d'une impédance électrochimique d'une microbatterie mesurée par spectroscopie pour différentes fréquences,

[Fig. 6] représente une base de données de mesures utilisées en entrée d'un procédé d'apprentissage selon l'invention,

[Fig. 7] représente un ensemble de courbes de références caractérisant une microbatterie fonctionnelle et plusieurs exemples de courbes caractérisant une microbatterie défectueuse,

[Fig. 8] illustre une étape de construction d'un noeud au cours de la génération d'un arbre via un algorithme d'apprentissage de type forêt aléatoire,

[Fig. 9] représente un exemple d'arbre généré par un algorithme d'apprentissage de type forêt aléatoire,

[Fig. 10] représente deux exemples de classification de microbatteries réalisées sur une plaque de Silicium et testées au moyen du procédé de classification automatique selon l'invention, et

[Fig. 11] représente un schéma d'un dispositif de test de batteries selon un mode de réalisation de l'invention.

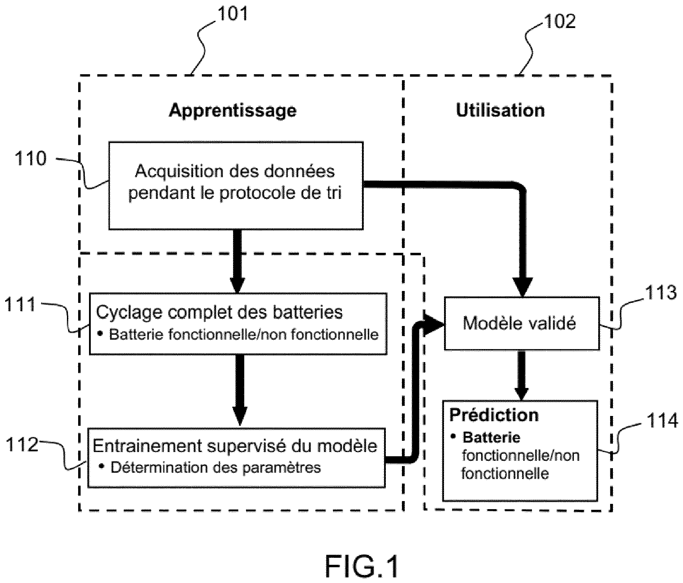

La figure 1 schématise un organigramme détaillant les étapes de mise en oeuvre de l'invention qui comporte deux phases distinctes, une première phase d'apprentissage 101 du modèle de classification réalisée sur un échantillon de plusieurs batteries et une seconde phase d'utilisation 102 du modèle entraîné et validé pour classifier de nouvelles batteries fabriquées dans deux catégories : batterie fonctionnelle ou batterie défectueuse.

La phase d'apprentissage 101 comporte une première étape d'acquisition 110 de données, par des mesures opérées sur chaque batterie, puis une étape de cyclage complet 111 des batteries comprenant au moins une charge complète et/ou une décharge complète de la batterie. L'étape de cyclage complet 111 comporte également une mesure de profil de charge et/ou de décharge permettant de caractériser la batterie comme appartenant à une catégorie fonctionnelle ou défectueuse. A partir des mesures acquises à l'étape 110 et de la labellisation en deux catégories réalisées à l'étape 111, un modèle de classification automatique supervisé est entraîné à l'étape 112 pour apprendre à classifier une batterie comme fonctionnelle ou défectueuse à partir des seules mesures réalisées à l'étape 110.

Une fois le modèle de classification entraîné et validé, il est utilisé lors de la seconde phase 102 pour être appliqué 113 directement à des mesures réalisées à l'étape 110 sur de nouvelles batteries fabriquées afin de les classifier directement (étape 114) dans les catégories fonctionnelle ou défectueuse sans passer par un cyclage complet de la batterie.

On détaille à présent chacune des étapes du procédé.

L'étape 110 de collecte de mesures de paramètres représentatifs du bon fonctionnement d'une batterie est réalisée à la fois pour la phase d'apprentissage 101, sur un ensemble donné de batteries, et aussi lors de la phase d'utilisation 102. On détaille un exemple de réalisation de l'étape 110 qui concerne plus particulièrement les microbatteries, en particulier les microbatteries de type « Li-free ». Sans sortir du cadre de l'invention, d'autres paramètres peuvent être envisagés pour caractériser le bon fonctionnement d'une batterie, en particulier d'un autre type.

Pour les microbatteries en particulier, les mesures suivantes sont envisagées pour caractériser leur état de fonctionnement.

Un premier type de mesure concerne une mesure de la tension de circuit ouvert ou OCV pour « Open Circuit Voltage ». Cette tension est mesurée pendant un intervalle de temps, par exemple égal à quelques secondes, dès la sortie de fabrication de la batterie avant toute sollicitation électrique. Une moyenne des valeurs de tension mesurées peut être réalisée sur l'intervalle de temps de mesure. Cette tension est mesurée directement aux bornes de la batterie.

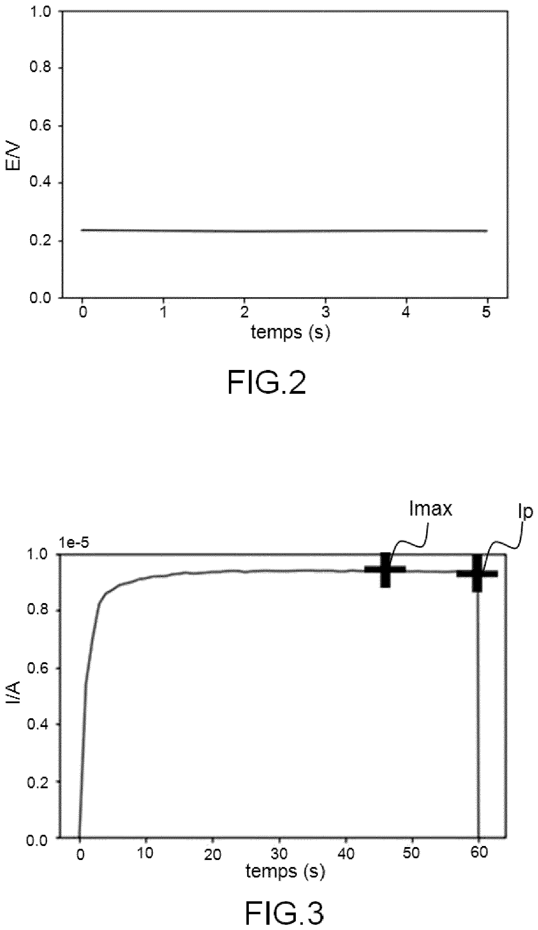

La figure 2 illustre un exemple de courbe de mesure de tension de circuit ouvert.

Un autre type de mesure concerne le profil de courant lors d'une charge partielle de la batterie. Pour cela, une charge partielle est initiée pendant un intervalle de temps, par exemple égal à 1 minute, en appliquant une tension prédéterminée (par exemple égale à 4.2 V) aux bornes de la batterie. On mesure alors pendant cet intervalle de temps le courant traversant la batterie et on obtient une courbe d'évolution de courant du type de celle représentée à la figure 3. Ce profil de courant peut être utilisé dans son intégralité ou bien certains points caractéristiques peuvent en être extraits, par exemple la valeur maximale du courant Imax ou la valeur de courant en fin de charge Ip. D'autres points de la courbe peuvent aussi être envisagés.

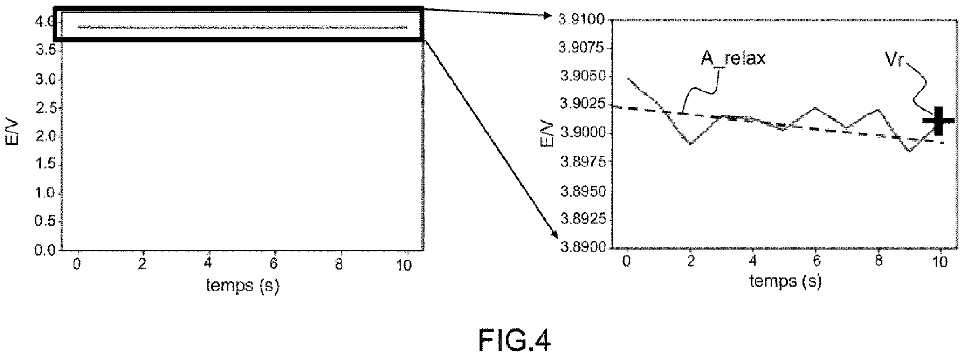

Après la charge partielle de la batterie, la sollicitation est stoppée et la relaxation en potentiel de la batterie sollicitée peut être recueillie en mesurant à nouveau la tension aux bornes de la batterie pendant un intervalle de temps donné. Un exemple d'une telle mesure est représenté à la figure 4 avec la courbe complète sur la gauche et un zoom en amplitude de cette courbe sur la droite.

Là aussi, certains points ou paramètres caractéristiques peuvent être retenus tels que la pente *a_relax* de la courbe de relaxation et le potentiel de fin de relaxation *Vr*.

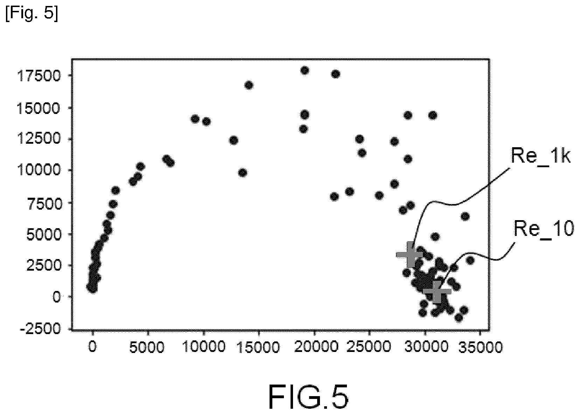

Un autre type de mesure est une mesure de spectroscopie d'impédance électrochimique qui peut être réalisée en sollicitant la batterie avec une tension sinusoïdale dont la fréquence varie dans une plage de fréquence donnée. La figure 5 illustre un exemple de représentation de Nyquist de l'impédance électrochimique mesurée avec la partie réelle de l'impédance en abscisse et l'opposé de la partie imaginaire de l'impédance en ordonnée. Chaque point de la courbe correspond à une fréquence d'excitation différente.

Tous les points de la courbe peuvent être retenus ou, avantageusement, certains points caractéristiques seulement, par exemple les résistances Re_1k, Re_10 mesurées aux fréquences de 1KHz et 10Hz donnent respectivement une mesure de la résistance interne du composant et une mesure de la remontée capacitive. Ces deux points de mesure sont particulièrement pertinents pour estimer le bon fonctionnement d'une microbatterie.

Dans le cas de microbatteries fabriquées sur plaques de silicium, une autre donnée collectée est la position (x,y) de chaque composant sur la plaque (ou « wafer »).

Une autre donnée collectée concerne l'étape de fabrication à l'issue de laquelle est réalisé le test. En particulier, les mesures peuvent être réalisées dès la fabrication des trois éléments principaux de la batterie, l'électrode positive, l'électrode négative et les contacts. Notamment les mesures peuvent être réalisées avant la fabrication des couches d'encapsulation qui protègent le composant de l'air et de l'humidité.

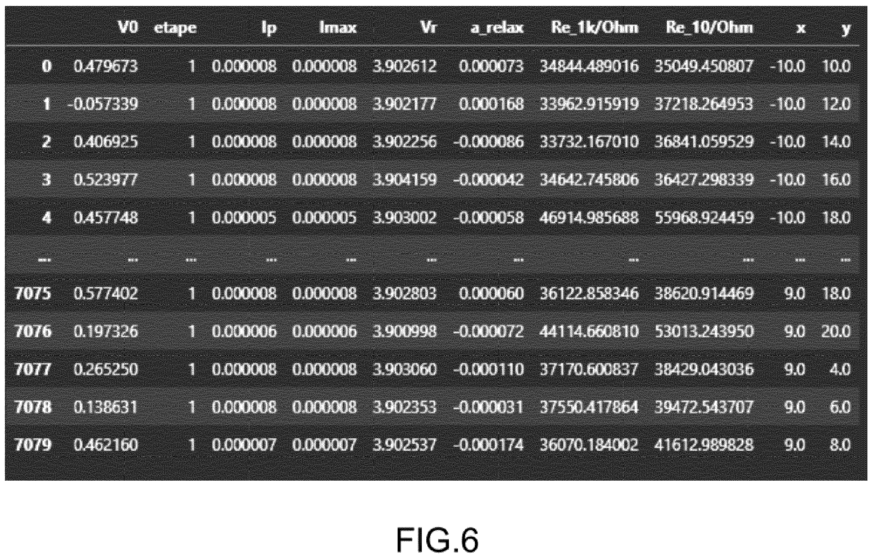

Toutes les mesures collectées sont rassemblées dans une base de données d'entrainement du type décrit à la figure 6 dont chaque ligne correspond à un composant testé et chaque colonne à l'un des paramètres mesurés.

Une fois l'ensemble des mesures réalisées, on passe à l'étape 111 qui consiste à réaliser un cyclage complet des batteries comprenant une charge complète et/ou une décharge complète.

Au cours du cyclage, on mesure une courbe de charge et/ou une courbe de décharge. La courbe de charge est par exemple une courbe de courant ou de capacité de charge. La courbe de décharge est par exemple une courbe de tension ou de capacité de décharge.

On compare pour chaque batterie, la ou les courbes mesurées avec des courbes de référence correspondant à un état fonctionnel de la batterie et on en déduit une classification de chaque batterie dans la catégorie fonctionnelle (si les mesures correspondent aux courbes de référence) ou dans la catégorie défectueuse (si les mesures ne correspondent pas aux courbes de référence).

Cette étape correspond à une étape d'annotation ou labellisation des données d'entrainement en vue de réaliser l'apprentissage du modèle de classification. Elle peut être réalisée manuellement ou automatiquement.

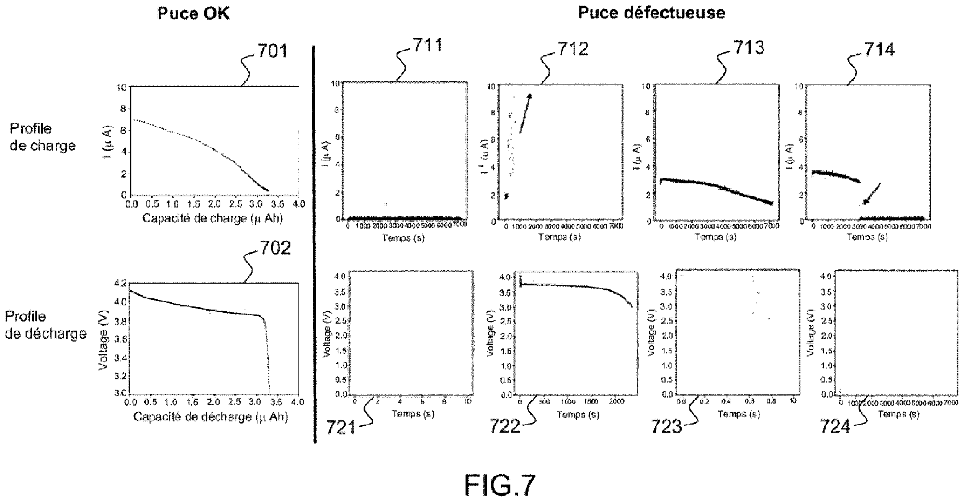

La figure 7 représente différentes courbes de profils de charge ou décharge d'une microbatterie permettant de caractériser des composants fonctionnels et des composants défectueux.

La figure 701 représente un exemple de courbe de profil de charge sous la forme d'une courbe de variation de l'intensité d'un courant de charge en fonction de la capacité de charge. Le profil d'évolution du courant est décroissant en fonction de la capacité de charge.

La figure 702 représente un exemple de courbe de profil de décharge sous la forme d'une courbe de variation de la tension aux bornes de la batterie en fonction de la capacité de décharge. Le profil d'évolution de la tension est décroissant en fonction de la capacité de décharge.

Les figures 711, 712, 713, 714 représentent différents profils de charge mesurés pour des puces défectueuses. Les figures 721, 722, 723, 724 représentent les courbes de profils de décharge correspondantes. Les courbes 711,721 correspondent à un défaut de type circuit ouvert pour lequel aucun courant n'est mesuré pendant la charge et la tension aux bornes de la batterie est nulle pendant la décharge. Les courbes 712, 722 correspondent à un défaut lié à un courant trop élevé pendant la charge. La courbe de charge 712 n'est pas conforme car le courant mesuré est trop élevé tandis que la courbe de décharge est partiellement conforme. Les courbes 713, 723 correspondent à un défaut de type efficacité faible pour lequel la charge de la batterie est conforme à l'attendu mais la décharge est inexistante. Enfin les courbes 714, 724 correspondent à un défaut de rupture de la couche métallique pour lequel le courant subit une rupture brutale au cours de la charge et aucune tension n'est mesurable au cours de la décharge.

D'autres exemples de profils de charge et/ou décharge correspondant à des puces défectueuses peuvent exister sans sortir du cadre de l'invention.

En comparant au moins la courbe de charge et/ou au moins la courbe de décharge aux courbes de référence 701, 702, on en déduit si la batterie est fonctionnelle ou défectueuse. La comparaison des courbes peut être réalisée visuellement ou de façon automatique par exemple en comparant une partie ou tous les points des courbes entre elles.

A l'issue de l'étape 111 on obtient une base de données d'entrainement avec, pour chaque microbatterie testée, l'ensemble des mesures associées réalisées à l'étape 110 et la catégorie « fonctionnelle » ou « défectueuse » déterminée à l'étape 111.

A partir de ces données d'entrainement, on réalise ensuite un entrainement supervisé 112 d'un modèle de classification qui a pour fonction de déterminer la catégorie d'une microbatterie à partir des seules mesures réalisées à l'étape 110 et ce, sans réaliser de cyclage complet de la batterie.

L'entrainement supervisé 112 peut être réalisé par tout algorithme ou moteur d'apprentissage non supervisé. On décrit un exemple de réalisation de cet entrainement mis en oeuvre au moyen d'un algorithme de forêt aléatoire ou « random forest » en anglais. D'autres algorithmes d'apprentissage automatique peuvent être envisagés, par exemple des réseaux de neurones profonds.

Les données obtenues à l'issue de l'étape 111 sont séparées en un ensemble de données d'entrainement et un ensemble de données de validation. Le modèle d'apprentissage automatique mis en oeuvre via un algorithme de forêt d'arbres de décision aléatoire est entraîné via les données d'entrainement. L'entrainement consiste à ajuster de manière itérative les paramètres du modèle afin de pouvoir prédire la catégorie de fonctionnalité des microbatteries au plus juste.

L'algorithme consiste à construire plusieurs arbres de décision en ajoutant de façon itérative des noeuds successifs. Chaque noeud est associé à une règle de décision à tester vis-à-vis des données d'entrée. Un exemple de règle de décision consiste à comparer une valeur d'une donnée d'entrée avec un seuil.

Pendant l'entrainement, chaque arbre de décision est construit à partir d'un sous-ensemble du jeu de données initial qui est de même taille que le jeu de données initial mais qui comporte des échantillons tirés au sort avec remise. Autrement dit, un même échantillon (correspondant à une batterie) peut être représenté plusieurs fois dans le sous ensemble utilisé pour l'entrainement.

Pour chaque règle de décision, un cout est calculé pour évaluer l'efficacité de la règle pour segmenter les données associées au noeud dans les catégories visées.

Le cout d'un noeud est, par exemple, calculé au moyen du critère de Gini :

$$GiniIndex = 1 - \sum_j p_j^2$$

, où $p_j$ est la probabilité d'une batterie associée à un noeud d'appartenir à la catégorie j, j étant égal à 0 ou 1 dans le cas présent où seules deux catégories sont visées.

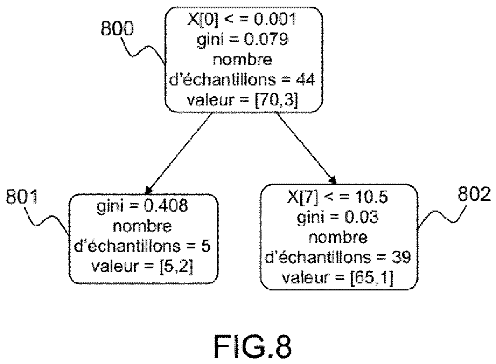

La figure 8 illustre un exemple de construction de noeuds successifs. Le noeud 800 est associé à une règle de comparaison de la première donnée X[0] (ici la valeur de la tension de circuit ouvert) à une valeur seuil de -0,001 V.

Pour chaque noeud, est identifié le nombre d'échantillons « uniques » qui vérifient la règle associée et le nombre total d'échantillons (y compris les échantillons multiples) qui appartiennent aux deux catégories (défectueuse ou fonctionnelle), ce nombre étant représenté par le champ « valeur = [x,y] » avec x le nombre d'échantillons appartenant à la catégorie défectueuse et y le nombre d'échantillons appartenant à la catégorie fonctionnelle.

En reprenant l'exemple de la figure 8, parmi les 73 échantillons associés au noeud 800, 7 ne vérifient pas l'inégalité du noeud 800 et sont associées au noeud 801 tandis que 66 vérifient l'inégalité du noeud 800 et sont associées au noeud 802. Parmi les 73 échantillons du noeud 800, seuls 44 sont des échantillons « uniques », les autres étant des copies de ces échantillons « uniques ».

Parmi les 7 batteries qui ne vérifient pas l'inégalité X[0]<=-0,001 (noeud 801), 5 batteries appartiennent à la catégorie défectueuse et 2 batteries appartiennent à la catégorie fonctionnelle. La population de chaque catégorie est à peu près équivalente et l'indice de Gini calculé vaut 0,408 ce qui est relativement élevé sachant que la valeur maximale de cet indice est de 0,5.

A l'inverse, parmi les 66 batteries qui vérifient l'inégalité X[0]<=-0,001 (noeud 802), 65 appartiennent à la catégorie défectueuse et une seule appartient à la catégorie fonctionnelle ce qui entraine un indice de Gini faible, égal à 0,03.

Le cout d'une règle est donné par la relation suivante :

$$J(k) = \frac{m_{gauche}}{m} G_{gauche} + \frac{m_{droite}}{m} G_{droite}$$

Où $J(k)$ est le coût du noeud de rang $k$, m est la population totale associée au noeud, $m_{gauche}$, $G_{gauche}$, $m_{droite}$, $G_{droite}$, respectivement les populations et indices de Gini des sous-noeuds gauche et droit créés par la règle de décision.

Dans l'exemple, ci-dessus, le coût de la règle de décision associée au noeud 800 vaut donc environ 0,067. Lors de l'entrainement du modèle, pour chaque rang, un grand nombre d'inégalités sont testées de manière aléatoire sur toutes les données d'entrée et celle ayant le coût le plus faible est conservée.

La construction d'un nouveau noeud de rang k+1 se poursuit ensuite en repartant du noeud, dans cet exemple le noeud 802, dont l'indice de Gini est le plus faible. Plusieurs critères peuvent être envisagés pour poursuivre la construction des noeuds suivants :

- La profondeur maximale, c'est à dire le nombre de niveaux maximal que peut avoir un arbre,

- Le nombre d'échantillons minimum à partir duquel un noeud peut être divisé en sous-noeuds, et

- Le nombre minimal d'échantillons dans chaque sous-noeud après une division. Par exemple si ce nombre est pris égal à 5, une division sera considérée uniquement si celle-ci a pour résultat la création de 2 sous-noeuds ayant au minimum 5 échantillons chacun.

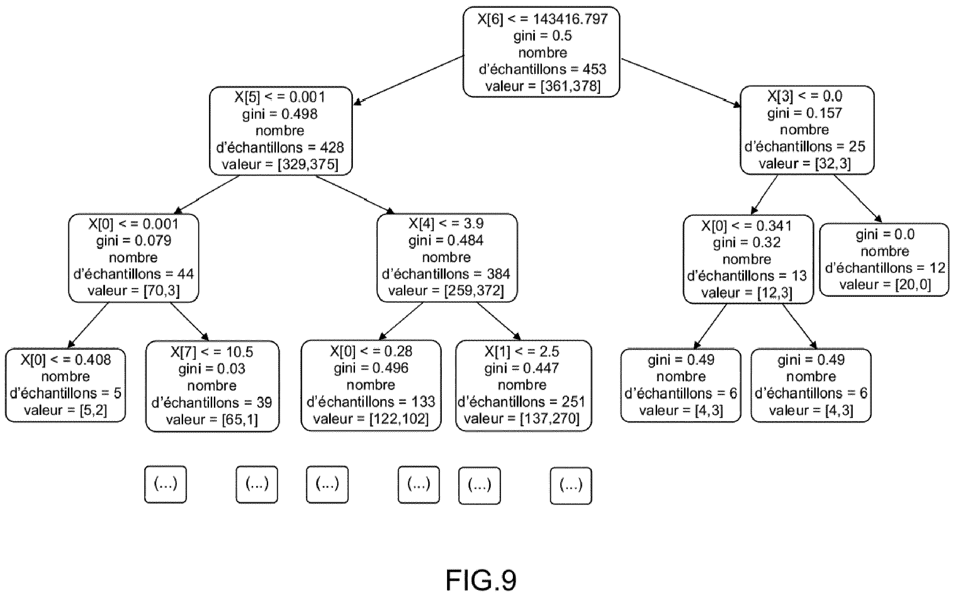

La figure 9 représente un exemple partiel d'arbre obtenu.

Les noeuds en pointillés se poursuivent via d'autres noeuds qui ne sont pas représentés par souci de clarté (l'arbre complet étant trop volumineux). La prédiction finale de l'arbre est donnée en comparant les valeurs mesurées pour chaque batterie aux inégalités de chaque noeud. En parcourant l'arbre de noeud en noeud, on arrive à un noeud feuille. Connaissant la répartition des catégories pour cette feuille pour les données d'apprentissage, on peut alors estimer une probabilité d'appartenance à l'une ou l'autre des catégories, et la catégorie la plus probable est attribuée à la batterie.

Autrement dit, la catégorie d'appartenance est celle pour laquelle le noeud feuille présente le plus grand nombre d'échantillons lors de l'apprentissage.

L'algorithme des forêts aléatoires génère plusieurs arbres du type de la figure 9 (de l'ordre d'une centaine par exemple) entraînés sur tout ou partie des données d'entrainement, de manière à réduire le phénomène de surapprentissage. La prédiction finale du modèle pour une batterie donnée est donnée par un vote majoritaire exprimé sur l'ensemble des arbres.

Optionnellement, le modèle de classification entraîné peut être évalué sur un ensemble de données de validation en calculant un score de prédiction sur les données d'entrainement et un score de prédiction sur les données de validation afin de vérifier si l'écart entre les deux scores n'est pas trop important. Si cet écart est trop important, un nouvel apprentissage peut être réalisé en modifiant les paramètres de l'algorithme.

Une fois le modèle de classification entraîné et validé, il est utilisé directement dans la phase d'utilisation lors de l'étape 114 pour prédire si une nouvelle batterie fabriquée est fonctionnelle ou défectueuse uniquement à partir des mesures 110 réalisées sur la batterie et sans réaliser un cyclage complet.

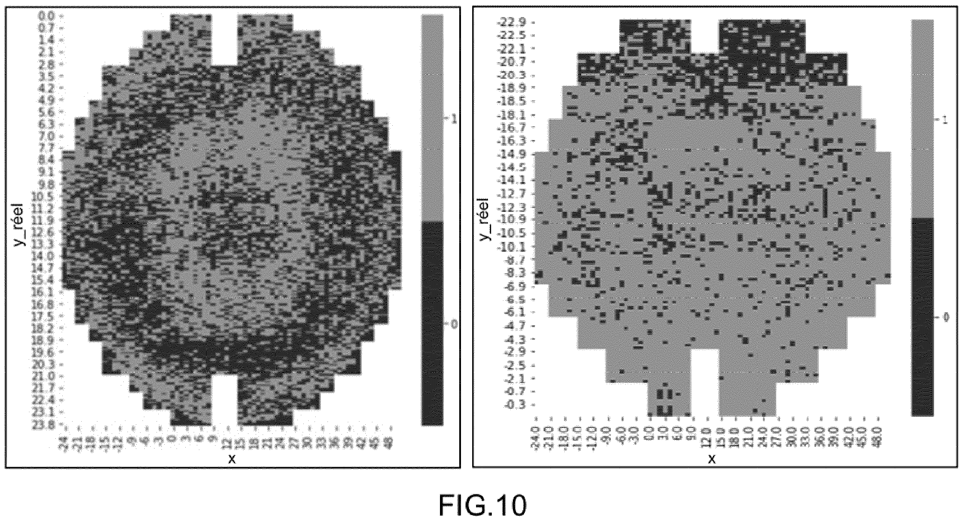

La figure 10 représente un exemple de prédictions obtenues à l'échelle d'une plaque de silicium sur laquelle des microbatteries sont fabriquées. Les batteries fonctionnelles sont identifiées par la catégorie '1' et les batteries défectueuses sont identifiées par la catégorie '0'.

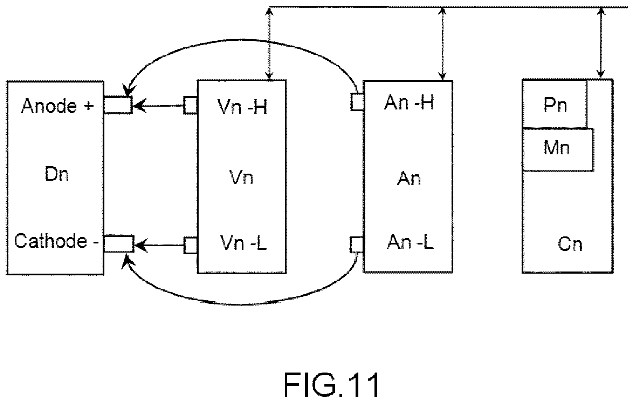

La figure 11 représente un schéma d'un système de test configuré pour mettre en oeuvre l'invention. La figure 11 représente à cet effet une batterie Dn ayant une anode et une cathode, un générateur de courant programmable An et un voltmètre programmable Vn connectés aux bornes de la batterie Dn pour réaliser les mesures nécessaires à l'étape 110 du procédé selon l'invention. Le système de test comporte un contrôleur Cn sous la forme d'une unité de traitement qui reçoit les mesures réalisées sur la batterie et implémente l'apprentissage et l'utilisation du modèle de classification pour prédire l'état fonctionnel ou défectueux de la batterie Dn. Le contrôleur Cn comporte au moins un processeur Pn et une mémoire Mn.

L'invention peut être mise en oeuvre en tant que programme d'ordinateur comportant des instructions pour son exécution. Le programme d'ordinateur peut être enregistré sur un support d'enregistrement lisible par un processeur.

La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro logiciel, un microcode, ou toute autre forme d'instruction d'ordinateur) qui peut être utilisé pour programmer un ou plusieurs processeurs pour mettre en oeuvre des aspects des techniques décrites ici. Les moyens ou ressources informatiques peuvent notamment être distribués (*"Cloud computing")*, éventuellement selon des technologies de pair-à-pair. Le code logiciel peut être exécuté sur n'importe quel processeur approprié (par exemple, un microprocesseur) ou coeur de processeur ou un ensemble de processeurs, qu'ils soient prévus dans un dispositif de calcul unique ou répartis entre plusieurs dispositifs de calcul (par exemple tels qu'éventuellement accessibles dans l'environnement du dispositif). Le code exécutable de chaque programme permettant au dispositif programmable de mettre en oeuvre les processus selon l'invention, peut être stocké, par exemple, dans le disque dur ou en mémoire morte. De manière générale, le ou les programmes pourront être chargés dans un des moyens de stockage du dispositif avant d'être exécutés. L'unité centrale peut commander et diriger l'exécution des instructions ou portions de code logiciel du ou des programmes selon l'invention, instructions qui sont stockées dans le disque dur ou dans la mémoire morte ou bien dans les autres éléments de stockage précités.

L'invention peut être implémentée sur un dispositif de calcul basé, par exemple, sur un processeur embarqué. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gate Array »). Le dispositif de calcul peut utiliser un ou plusieurs circuits électroniques dédiés ou un circuit à usage général. La technique de l'invention peut se réaliser sur une machine de calcul reprogrammable (un processeur ou un micro-contrôleur par exemple) exécutant un programme comprenant une séquence d'instructions, ou sur une machine de calcul dédiée (par exemple un ensemble de portes logiques comme un FPGA ou un ASIC, ou tout autre module matériel).

**Revendications**

1. Procédé, mis en oeuvre par ordinateur, d'apprentissage automatique (101) d'un modèle de classification de batteries en deux catégories : fonctionnel ou défectueux, le procédé comprenant les étapes de :

   - Acquérir (110), sur un ensemble de batteries de même type, un groupe de mesures caractéristiques du fonctionnement d'une batterie,
   - Réaliser (111) un cyclage complet de chaque batterie dudit ensemble et mesurer au moins une courbe parmi une courbe de charge ou une courbe de décharge de la batterie,
   - Déterminer (111), pour chaque batterie, un label d'appartenance à la catégorie fonctionnel ou défectueux en comparant l'au moins une courbe mesurée à une courbe de référence caractérisant le bon fonctionnement de la batterie, et
   - Réaliser (112) un entrainement supervisé d'un modèle de classification d'une batterie selon les deux catégories à partir desdits groupes de mesures et dudit label d'appartenance à l'une des deux catégories.

2. Procédé d'apprentissage automatique selon la revendication 1 dans lequel l'entrainement supervisé du modèle de classification est réalisé au moyen d'un algorithme de forêt aléatoire.

3. Procédé d'apprentissage automatique selon l'une quelconque des revendications précédentes dans lequel le groupe de mesures caractéristiques du fonctionnement d'une batterie comporte au moins une mesure de tension de circuit ouvert aux bornes de la batterie, par exemple une mesure moyenne sur un intervalle de temps prédéterminé.

4. Procédé d'apprentissage automatique selon l'une quelconque des revendications précédentes dans lequel le groupe de mesures caractéristiques du fonctionnement d'une batterie comporte au moins une mesure de profil de courant traversant la batterie au cours d'une charge partielle.

5. Procédé d'apprentissage automatique selon la revendication 4 dans lequel la mesure de profil de courant est réalisée en au moins un point particulier parmi une valeur maximale de courant et une valeur de courant en fin de charge partielle.

**6.** Procédé d'apprentissage automatique selon l'une quelconque des revendications précédentes dans lequel le groupe de mesures caractéristiques du fonctionnement d'une batterie comporte au moins une mesure de profil de tension aux bornes de la batterie au cours d'une relaxation de la batterie suivant une charge partielle.

**7.** Procédé d'apprentissage automatique selon la revendication 6 dans lequel la mesure de profil de tension comporte au moins une estimation par régression linéaire de la pente de la courbe de tension au cours de la décharge et/ou la mesure d'un potentiel de fin de relaxation.

**8.** Procédé d'apprentissage automatique selon l'une quelconque des revendications précédentes dans lequel le groupe de mesures caractéristiques du fonctionnement d'une batterie comporte au moins une mesure de spectroscopie d'impédance électrochimique réalisée en excitant la batterie avec un signal à au moins une fréquence prédéterminée.

**9.** Procédé d'apprentissage automatique selon la revendication 8 dans lequel la mesure de spectroscopie d'impédance électrochimique est réalisée pour au moins deux fréquences prédéterminées à 1000 Hz et 10Hz.

**10.** Procédé d'apprentissage automatique selon l'une quelconque des revendications précédentes dans lequel le groupe de mesures caractéristiques du fonctionnement d'une batterie comporte au moins une mesure de la position d'une batterie sur une plaque de fabrication.

**11.** Procédé d'apprentissage automatique selon l'une quelconque des revendications précédentes dans lequel les batteries sont de type batteries solides Li-free.

**12.** Procédé de test (102) d'un ensemble de batteries comprenant les étapes de, pour chaque batterie :

   - Acquérir (110) le même groupe de mesures utilisé pour entraîner le modèle de classification obtenu au moyen du procédé d'apprentissage automatique selon l'une quelconque des revendications précédentes, et
   - Mettre en oeuvre le modèle de classification (113) obtenu pour déterminer (114), à partir dudit groupe de mesures, si la batterie appartient à la catégorie fonctionnel ou défectueux.

**13.** Dispositif de test d'un ensemble de batteries comprenant un équipement de mesure (Vn,An) et un dispositif de calcul (Cn) configurés ensemble pour exécuter le procédé de test selon la revendication 12.

**14.** Produit programme d'ordinateur comprenant des instructions de code qui conduisent le dispositif de test selon la revendication 13 à exécuter les étapes de l'un quelconque des procédés selon l'une quelconque des revendications 1 à 12, lorsque ledit programme est exécuté sur un ordinateur.

**FIG.1**

FIG.2

FIG.3

FIG.4

[Fig. 5]

FIG.5

EP 4 253 973 A1

| | V0 | etape | Ip | Imax | Vr | a_relax | Re_1k/Ohm | Re_10/Ohm | x | y |
|---|---|---|---|---|---|---|---|---|---|---|
| 0 | 0.479673 | 1 | 0.000008 | 0.000008 | 3.902612 | 0.000073 | 34844.489016 | 35049.450807 | -10.0 | 10.0 |
| 1 | -0.057339 | 1 | 0.000008 | 0.000008 | 3.902177 | 0.000168 | 33962.915919 | 37218.264953 | -10.0 | 12.0 |
| 2 | 0.406925 | 1 | 0.000008 | 0.000008 | 3.902256 | -0.000086 | 33732.167010 | 36841.059529 | -10.0 | 14.0 |
| 3 | 0.523977 | 1 | 0.000008 | 0.000008 | 3.904159 | -0.000042 | 34642.745806 | 36427.298339 | -10.0 | 16.0 |
| 4 | 0.457748 | 1 | 0.000005 | 0.000005 | 3.903002 | -0.000058 | 46914.985688 | 55968.924459 | -10.0 | 18.0 |
| ... | ... | ... | ... | ... | ... | ... | ... | ... | ... | ... |
| 7075 | 0.577402 | 1 | 0.000008 | 0.000008 | 3.902803 | 0.000060 | 36122.858346 | 38620.914469 | 9.0 | 18.0 |
| 7076 | 0.197326 | 1 | 0.000006 | 0.000006 | 3.900998 | -0.000072 | 44114.660810 | 53013.243950 | 9.0 | 20.0 |
| 7077 | 0.265250 | 1 | 0.000008 | 0.000008 | 3.903060 | -0.000110 | 37170.600837 | 38429.043036 | 9.0 | 4.0 |
| 7078 | 0.138631 | 1 | 0.000008 | 0.000008 | 3.902353 | -0.000031 | 37550.417864 | 39472.543707 | 9.0 | 6.0 |
| 7079 | 0.462160 | 1 | 0.000007 | 0.000007 | 3.902537 | -0.000174 | 36070.184002 | 41612.989828 | 9.0 | 8.0 |

FIG.6

Puce OK

Puce défectueuse

701 — Profile de charge

702 — Profile de décharge

711 — 712 — 713 — 714

721 — 722 — 723 — 724

FIG.7

800

X[0] < = 0.001
gini = 0.079
nombre
d'échantillons = 44
valeur = [70,3]

801

gini = 0.408
nombre
d'échantillons = 5
valeur = [5,2]

X[7] < = 10.5
gini = 0.03
nombre
d'échantillons = 39
valeur = [65,1]

802

FIG.8

FIG.9

FIG.10

FIG.11

# EP 4 253 973 A1

**Europäisches Patentamt**
**European Patent Office**
**Office européen des brevets**

## RAPPORT DE RECHERCHE EUROPEENNE

Numéro de la demande

**EP 23 16 4241**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2010/312733 A1 (SONG HYUN-KON [KR] ET AL) 9 décembre 2010 (2010-12-09) | 1,3, 10-14 | INV.<br>G01R31/367 |
| Y | * abrégé *<br>* figures 1,2 *<br>* alinéas [0001] – [0006], [0011] – [0018] *<br>* alinéas [0031] – [0105], [0119], [0120] * | 2,4-11 | G01R31/36<br>G01R31/385<br>B07C5/344<br>H01M10/42 |
| Y | WO 2019/046555 A1 (FEASIBLE INC [US]; UNIV PRINCETON [US]) 7 mars 2019 (2019-03-07)<br>* abrégé *<br>* alinéas [0007] – [0009], [0023] – [0036] *<br>* alinéas [0049] – [0072] *<br>* figures 2,7 * | 2 | |
| Y,D | FR 3 112 213 A1 (COMMISSARIAT ENERGIE ATOMIQUE [FR]) 7 janvier 2022 (2022-01-07)<br>* le document en entier * | 4-7,11 | |
| Y | WO 2021/189146 A1 (CADEX ELECTRONICS INC [CA]) 30 septembre 2021 (2021-09-30)<br>* Tout le document, en particulier paragraphes [0049], [0113], [0139]-[0165], [0165], [0182]-[0183], [0341], [0368]-[0381] * | 8-11 | DOMAINES TECHNIQUES RECHERCHES (IPC)<br><br>G01R<br>B07C<br>H01M |

Le présent rapport a été établi pour toutes les revendications

| Lieu de la recherche | Date d'achèvement de la recherche | Examinateur |
|---|---|---|
| Munich | 7 juillet 2023 | Poizat, Christophe |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

...................................................................................
& : membre de la même famille, document correspondant

EPO FORM 1503 03.82 (P04C02)

**EP 4 253 973 A1**

## ANNEXE AU RAPPORT DE RECHERCHE EUROPEENNE
## RELATIF A LA DEMANDE DE BREVET EUROPEEN NO.

**EP 23 16 4241**

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

**07-07-2023**

| Document brevet cité au rapport de recherche | Date de publication | Membre(s) de la famille de brevet(s) | Date de publication |
|---|---|---|---|
| US 2010312733 A1 | 09-12-2010 | CN 101803104 A | 11-08-2010 |
| | | EP 2206191 A2 | 14-07-2010 |
| | | JP 5313250 B2 | 09-10-2013 |
| | | JP 2010539473 A | 16-12-2010 |
| | | KR 20090020448 A | 26-02-2009 |
| | | US 2010312733 A1 | 09-12-2010 |
| | | WO 2009035288 A2 | 19-03-2009 |
| WO 2019046555 A1 | 07-03-2019 | CA 3073833 A1 | 07-03-2019 |
| | | CN 111344894 A | 26-06-2020 |
| | | EP 3676902 A1 | 08-07-2020 |
| | | JP 7293197 B2 | 19-06-2023 |
| | | JP 2020537114 A | 17-12-2020 |
| | | KR 20200086254 A | 16-07-2020 |
| | | TW 201931661 A | 01-08-2019 |
| | | US 2019072614 A1 | 07-03-2019 |
| | | US 2022206075 A1 | 30-06-2022 |
| | | WO 2019046555 A1 | 07-03-2019 |
| FR 3112213 A1 | 07-01-2022 | CN 113884907 A | 04-01-2022 |
| | | EP 3933423 A1 | 05-01-2022 |
| | | FR 3112213 A1 | 07-01-2022 |
| | | JP 2022013743 A | 18-01-2022 |
| | | US 2022003821 A1 | 06-01-2022 |
| WO 2021189146 A1 | 30-09-2021 | US 2023122362 A1 | 20-04-2023 |
| | | WO 2021189146 A1 | 30-09-2021 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 9209496 B
- US 6526361 B

- FR 3112213

**Littérature non-brevet citée dans la description**

- **NEUDECKER.** *J. Electrochem. Soc.-,* 2000, 517-23